# EUROPEAN PATENT SPECIFICATION

(11) **EP 0 595 549 B1**
(45) Date of publication and mention of the grant of the patent: **10.09.1997**
(21) Application number: 93308393.3
(22) Date of filing: 21.10.1993
(51) Int. Cl.: G06K 19/077

(54) **Radio frequency baggage tags**
Radiofrequenzgepäcksanhänger
Etiquette-adresse à radiofréquence

(30) Priority: 26.10.1992 GB 9222460
(43) Date of publication of application: 04.05.1994
(73) Proprietor: HUGHES MICROELECTRONICS EUROPA LIMITED, Glenrothes Fife KY7 5PY Scotland (GB)
(72) Inventor: Bradley, Laurence David, Ipswich IP4 5BQ (GB); Deagle, Edwin, Niguel California 92677 (US); Glover, Stephen, Glenrothes Fife Scotland (GB); Harris, Susan, Fife Scotland (GB)
(74) Representative: Colgan, Stephen James

(56) References cited:
- EP-A- 0 492 569
- EP-A- 0 537 378
- WO-A-86/04172
- WO-A-93/12513
- DE-A- 4 002 738
- DE-A- 4 003 212

## Description

### BACKGROUND OF THE INVENTION

### 1. Field of the Invention

The present invention relates to radio frequency identification tags for airline baggage and similar articles and more particularly concerns incorporation of such an identification tag into a standard baggage identification label.

### 2. Description of Related Art

It has been the practice for some time to identify personal luggage transported by common carrier, such as airlines, by use of flexible self-adhering paper label strips which encircle a luggage handle and are secured by self-adhesive end portions of the strip. The identification labels commonly are color coded and imprinted with various identification of carrier, destination and other indicia to facilitate sorting, routing and other baggage handling operations. Such identification labels frequently will also include optical bar codes that enable machine reading by optical bar code readers. The optical bar code reader enables machine or automatic identification routing and handling that allow luggage processing to be carried out at higher speed and with fewer errors. Nevertheless optical systems suffer from several disadvantages. Optical readers and bar codes are restricted to line of sight use. The label must be properly oriented to cause the bar code to face the reader. Obstructions that may be positioned between the bar code and optical reader totally disable optical reading. Optical bar code systems are relatively expensive and are capable of storing only a limited amount of data.

Accordingly, it is an object of the present invention to provide for luggage and other object identification and handling by methods and apparatus that minimize or avoid above-mentioned problems.

WO-A-93/12513, cited under Article 54(3) EPC, describes a security sealing device consisting of a support onto one side of which is bonded an electronic security circuit which mainly consists of a fine wire winding connected to an electrical component. The electrical component may be coded so that, when it is activated and read by an external controller via the winding acting as an antenna, it sends out a code.

### SUMMARY OF THE INVENTION

In carrying out principles of the present invention, a remotely readable identification tag as specified in claim 1 hereinafter comprises a flexible substrate, an antenna formed on the substrate, a transponder circuit chip, means for mounting the chip on the substrate and means for electrically connecting the chip to the antenna. The circuit chip includes electrical contact chip pads on an inner surface portion of the chip and electrically conductive adhesive is interposed between electrical contact antenna pads and the chip pads. The invention also relates to a method of forming tags as specified in claim 11 hereinafter, and a continuous multi-label strip of labels as specified in claim 18 hereinafter.

### BRIEF DESCRIPTION OF THE DRAWINGS

In the accompanying drawings:
FIG. 1 is a pictorial illustration of a flexible paper identification label for airline luggage embodying both an optical bar code and a radio frequency transponder tag;
FIG. 2 is a plan view of a typical antenna;
FIG. 3 is a sectional view showing features of the antenna of FIG. 2;
FIG. 4 is a plan view of a transponder circuit chip;
FIG. 5 is a sectional view of the chip;
FIG. 6 illustrates one means of assembly of the chip to the antenna and substrate;
FIG. 7 shows a subsequent step in the assembly;
FIG. 8 shows a still further step in the assembly;
FIG. 9 shows a section of a completed RF tag;
FIGS. 10, 11 and 12 illustrate various alternate antenna pad configurations;
FIG. 13 shows an alternative antenna configuration;
FIG. 14 is a section of the antenna of FIG. 13;
FIGS. 15 and 16 are simplified plan and elevation views of a single identification label; and
FIGS. 17 and 18 illustrate a strip of multiple labels before and after folding.

### DESCRIPTION OF THE PREFERRED EMBODIMENTS

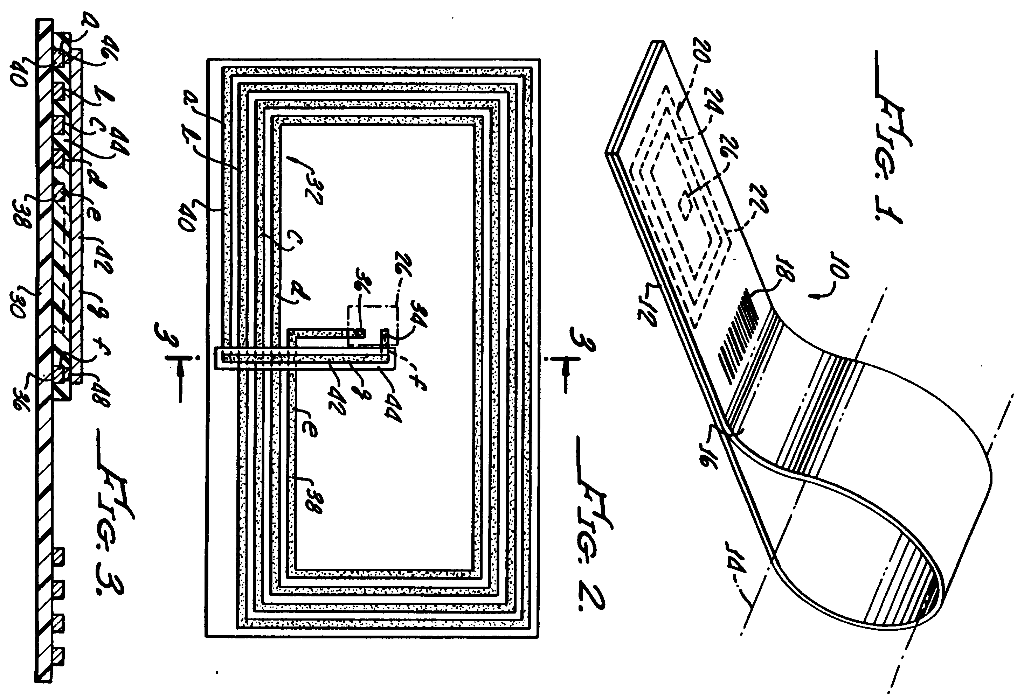

As shown in FIG. 1, an elongated luggage identification label, generally indicated at 10, is formed of a thin elongated paper strip 12 that is looped around a luggage handle, part of which is illustrated at 14, so that one end 16 of the paper strip 12 which bears a self-sticking adhesive (not shown) may be adhesively secured to the other end of the paper strip to thereby permanently secure the identification label to the luggage handle. An optical bar code 18 is formed on a readily visible outer portion, such as the outer portion of the end 16 of the label, and additional indicia in the form of printing and/or color coding (not shown) is generally provided on the identification label surface.

The identification label of FIG. 1 embodies still another form of data in the form of an RF (radio frequency) tag, generally indicated at 20, which is suitably secured as by adhesive (as will be described more particularly below) to a surface of one end of the identification label 10. This tag is covered by the label end 16 when the latter is folded over and secured to the other end of the label as shown in FIG. 1. In general the RF tag comprises a thin, flexible transparent substrate 30 bearing a transponder antenna 24 and a transponder circuit chip 26 all encased in a suitable protective covering material.

The transponders described herein are employed in remote magnetically coupled identification systems of the type shown in United States Patent 4,730,188 to Milheiser. The antenna 24 and integrated transponder circuit 26 embody circuit of the nature described in detail in the Milheiser patent. Transponders of this type are made by Hughes Identification Devices, Inc. and sold as Proxcard (trade mark) readers or other types of transponder systems which include various types of readers, scanners and transponders for a variety of identification purposes. Such devices have reading ranges in the order of 20 to 30 cm (eight to twelve inches).

As shown in the patent to Milheiser and described in detail therein, and as embodied in the Hughes Identification Devices products, this type of magnetically coupled identification system includes a reader/exciter (not shown) that transmits a radio frequency interrogation signal at a frequency which may be, for example, in the order of about 27 MHz. The transmitted interrogation signal produces a magnetic flux field that is magnetically coupled to the transponder antenna to energize the latter and provide power for the transponder identification and data readout circuitry. The latter carries no battery or other source of stored power. Upon energization of its antenna the transponder identification circuitry assembles an identification code or information signal and other data that are stored in the memory of the transponder. The assembled information signal may contain identification code and other data related to the individual luggage tag. This information signal is fed to the transponder antenna to cause the latter to transmit a return or information signal that is received by the reader/exciter, where it is detected and employed for selected use. Prior transponders, including various combinations of antenna and chip, have been mounted on rigid printed circuit boards, and therefore are unsuitable for attachment to a flexible paper identification label.

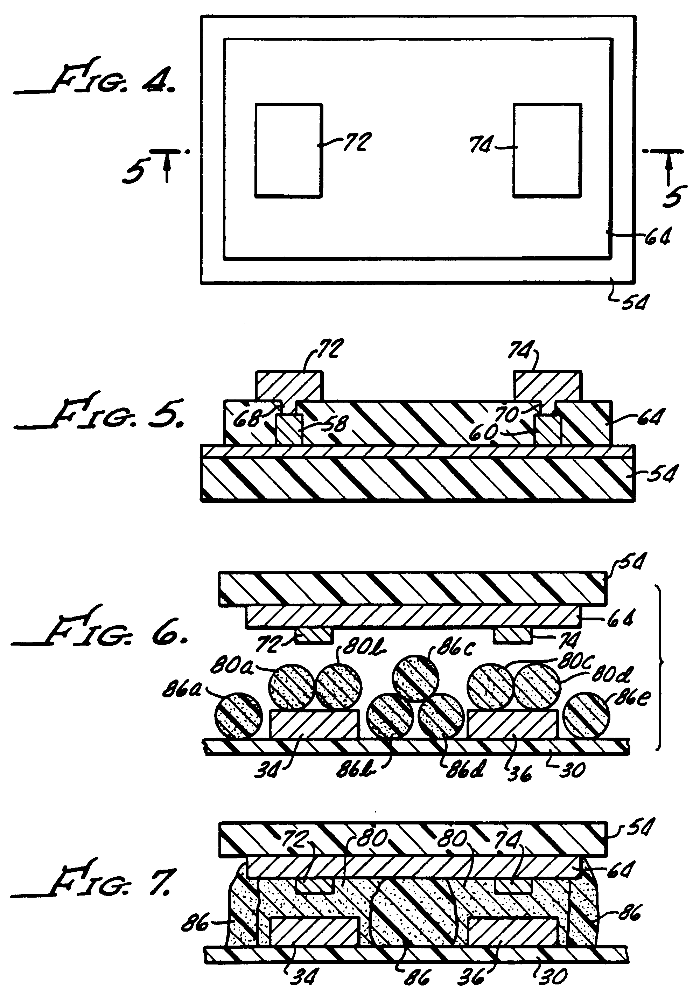

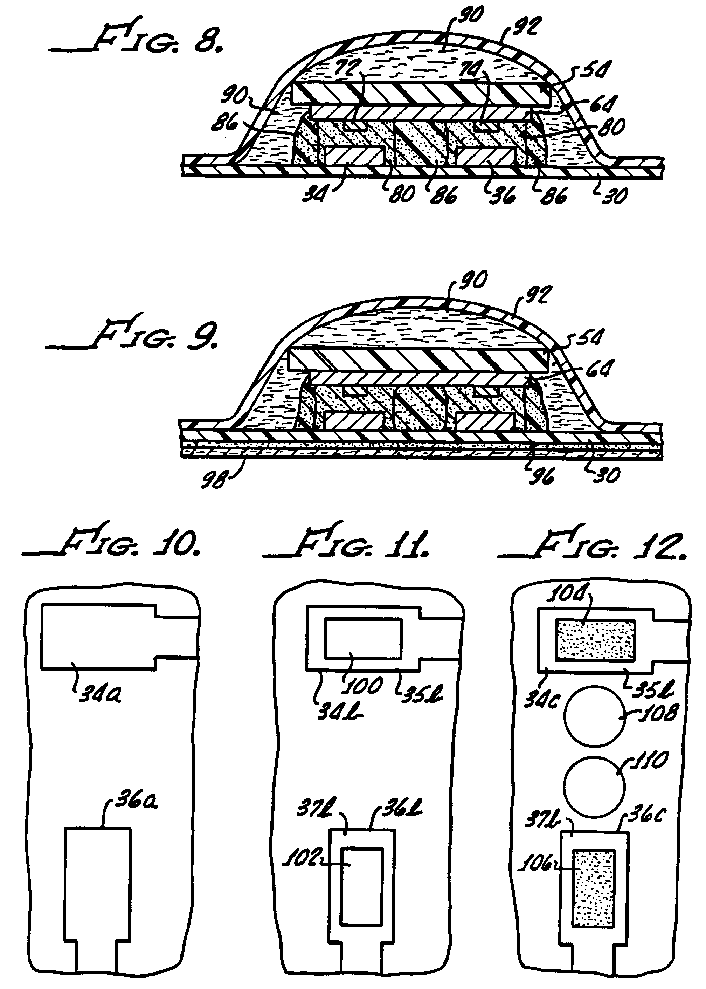

According to one embodiment of the present invention, the transponder is formed on a thin, flexible transparent strip of electrically nonconductive material, such as a polyester strip 30 (FIG. 2). A plurality of turns 32 of electrically conductive material are formed as by conventional printed circuit techniques including electroforming, standard etching or screen printing processes on the dielectric polyester substrate. The antenna turns are designated by reference numeral 32. The antenna includes electrical contact antenna pads 34,36. In an exemplary arrangement the antenna includes six turns formed in a generally rectangular configuration, having an overall width of 4 centimeters and an overall length of 7 centimeters, for example, and having an innermost turn 38 and an outermost turn 40. An end of the innermost turn 38 is brought to a central area of the space circumscribed by the inner turn to position a first antenna contact pad 36 substantially adjacent the center of the antenna. An end portion 40 of the outermost turn is connected to the second antenna contact pad 34 by a bridging conductor 42 that extends from end portion 40 of the outer turn to the second antenna pad 34, which is closely adjacent the first antenna pad 36. To form the bridging conductor 42 a strip of dielectric material 44 (FIG. 3) is laid down over and across antenna turns at one side of the antenna, and a pair of vias 46,48 are formed through the dielectric 44 and filled with an electrically conductive material to connect opposite ends of the bridging conductor 42 to the outer antenna turn 40 and the inner antenna pad 34.

In a typical example the 4 x 7 centimeter antenna coil is formed of conductive traces each having a width of 0.76 to 1.02 mm (0.030 inches to 0.040 inches), separated by spaces of similar width, and all having a resistivity of less than about 50 milliohms per square. The antenna pads may be square, having a dimension on each side of between about 1.02 to 1.27 mm (0.040 and 0.050 inches). The substrate 30 is substantially the same size as the antenna coil, being slightly larger than the outermost turn of the antenna to provide a continuous margin around the entire antenna of approximately 3 to 5 millimeters.

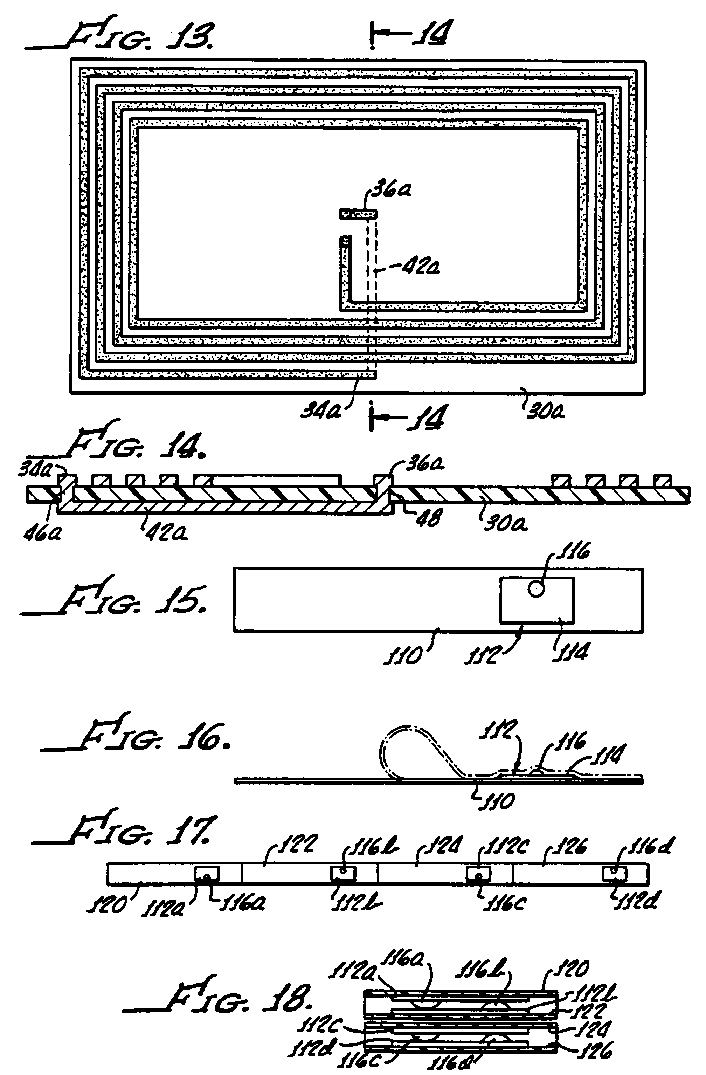

A double metal layer integrated circuit chip 26 containing all of the transponder circuitry is formed of a substrate 54 bearing circuitry generally indicated at 56 on a first surface (upper surface as viewed in FIG. 5). Primary chip contact pads 58,60 are connected to appropriate points of the transponder circuitry on an inner portion of the chip and project upwardly from the chip by a small distance. Preferably the pads 58,60 have a small area so as to use as small an area as possible of the chip surface. Use of small contact or connecting pads allows the circuitry to occupy larger areas of a small chip. A layer of dielectric 64 is laid down on the surface of the chip to cover and protect the circuit and to surround and encompass the pads 58,60. Dielectric 64 is formed with a pair of vias 68,70 which receive portions of a conductive material, such as aluminum, that is laid down on the upper surface (as viewed in FIG. 5) of the dielectric 64 to form secondary electrical contact chip pads 72,74. A plan view of the chip and its secondary contacts is shown in FIG. 4. The described arrangement enables the secondary metal pads 72,74 to be significantly larger than the primary pads so as to actually overlay portions of the chip circuitry (with interposed dielectric), and yet the arrangement utilizes no more of the chip area than is required for the much smaller primary pads 58,60. In an exemplary embodiment the overall size of the chip is about 2.54 by 1.78 mm (0.1 inches by 0.07 inches), with each of the larger secondary pads 72,74 having a dimension of approximately 0.38 to 0.51 mm (0.015 by 0.02 inches). The two secondary pads 72,74 are spaced from one another by about 1.02 mm (0.04 inches), which is the same spacing as the spacing of the antenna pads.

The transponder chip of FIGS. 4 and 5 is mounted to the antenna by procedures illustrated in FIGS. 6 through 9 by adhesively securing the chip pads to the antenna pads, employing a suitable electrically conductive adhesive. A nonconductive structural adhesive is also used to ensure greater structural integrity.

As illustrated in FIG. 6 for example, small quantities or dots of electrically conductive adhesive 80a - 80d are deposited on the antenna pads 34,36 and small quantities or dots of a structural adhesive 86a - 86e are deposited on the substrate between and at outer sides of the antenna pads. FIG. 6 illustrates the various adhesives placed as dots onto the antenna pads prior to chip placement. If desired the adhesive can also be screen printed in place. The silicon chip 54 is then positioned over the antenna with the chip pads aligned with the antenna pads. The chip is pressed down against the substrate and its antenna. The adhesive is pressed between the pads and between the chip and substrate. It is then cured under suitable pressure and temperature to cause the electrically conductive adhesive 80 to flow over and around both the antenna pads and the chip pads and the electrically nonconductive structural adhesive 86 to flow, as shown in FIG. 7, around the edges of the chip, between the chip and the substrate, and between conductive adhesive that connects the two chip pads and the two antenna pads. The nonconductive structural adhesive 86 that is positioned between two separate portions of the conductive adhesive 80 not only provides for greater structural rigidity but further ensures electrical insulation of the two chip pads from each other and insulates the two antenna pads from each other.

The conductive adhesive can be an anisotropic or Z-axis adhesive, such as the adhesives produced by A. I. Technologies or an isotropic epoxy such as "Abelbond 967-1" or thermoplastic isotropic adhesives such as "Staystik 181". Suitable nonconductive adhesives may be those known as "Abelbond 967-3" and "Staystik 373". It is important that the electrically conductive and electrically nonconductive adhesives be compatible with regard to characteristics such as thermal expansion coefficient and mechanical response.

FIG. 7 illustrates the adhesive after placing of the chip and after application of heat and pressure. If deemed necessary or desirable, the nonconductive adhesive, which requires temperature and pressure for full curing, can be formed with a small percentage of an ultraviolet curing agent (in the order of about 5% for example) so that the structural adhesive may be partially cured by application of ultraviolet light immediately after chip placement. This allows the chip to be "tacked" into place by the ultraviolet light before it is transported to be cured or dried.

The described arrangement of adhesive bonding and the relatively large antenna and chip pads greatly ease tolerances required of antenna and chip pad positioning and also tolerances for chip positioning (relative to the antenna) for assembly of the transponder. It is not necessary for the pads of the chip and the antenna to actually be touching or even to be perfectly aligned due to the nature of the electrical conduction through the conductive adhesive. As long as there is a high percentage of overlap of a chip pad with an antenna pad, the device will function properly. Accordingly, the described arrangement eases production tolerances and decreases production cost.

After bonding the chip to the substrate, both electrically and structurally, the chip is protected from external forces and conditions by depositing a body of ultraviolet sensitive material 90 over the chip, as shown in FIG. 8. This material is cured by application of ultraviolet light and also acts as additional structural adhesive to increase rigidity of the of the transponder in the area immediately adjacent the chip.

To provide further protection for the silicon chip and printed antenna a thin self-adhesive electrically non-conductive polyester layer or cover coat 92 may then be deposited over the entire area of the tag substrate and over the protective material 90. This provides a smooth continuous outline to facilitate passage of the RF tag through a bar code printing machine and through a suitable machine for writing into the transponder memory. The cover coat 92 also protects the antenna coil.

To facilitate securing of the RF transponder tag to the conventional paper luggage identification label, the opposite side (the bottom as viewed in FIG. 9) of the thin, transparent flexible polyester substrate 30 is provided with an adhesive layer 96 protected by a peel-off paper layer 98. Adhesive 96 may be a high performance adhesive, such as 3M adhesive 467 MIP, for example. Accordingly, to apply the RF transponder tag to the airline baggage identification label the cover paper 98 is simply removed and the tag is pressed against the baggage label, which may be done for example in the machine that prints the optical bar code.

Instead of providing for a relatively square configuration of antenna conductive pad, these pads may be of a rectangular configuration, as illustrated in FIG. 10 for pads 34a and 34b. This rectangular configuration is important for situations where the thin, flexible, transparent polyester substrate may be stretched during processing. For example, it is contemplated to manufacture a plurality of the described transponders in a continuous assembly line arrangement wherein the thin strip of polyester substrate is extracted from a large continuous roll of polyester strip material having sprocket holes for indexing and for pulling the strip from its roll. During such extraction the substrate is subject to longitudinal stretching, and thus the rectangular pad configuration is provided with the long dimension of the pad rectangle aligned with the length of the elongated strip of substrate material so that any stretching of the substrate is less likely to displace the antenna pad to a position where it would no longer be capable of registering with a pair of chip pads. The use of elongated pads allows the substrate to be stretched without adversely affecting the assembly, and thus allows the use of large reels of substrate that may be greater than 500 meters in length for use in continuous production.

Still another alternative antenna pad construction is illustrated in FIGS. 11 and 12 in which antenna pads 34b and 36b are made in a roughly "O" shape with a strip of conductive material 35b,37b completely and continuously circumscribing an enclosed area 100,102. The enclosed area 100,102 is then filled with an electrically conductive adhesive 104,106, as shown in FIG. 12. In this arrangement the circumscribing conductive strips 35b,37b act as retaining wall for the conductive adhesive 104,106 when the latter is subject to heat and pressure and begins to flow. This arrangement allows the chip pad spacing to be reduced if necessary. FIG. 12 also shows the electrically nonconductive structural adhesive 108,110 that is applied to the substrate surface between the antenna pads, illustrating the fact that the circumscribing pad leads 35b and 37b not only constrain the electrically conductive adhesive 104,106, but also tend to constrain the electrically nonconductive structural adhesive 108,110 and prevents intermixing of the two.

An alternate antenna arrangement is illustrated in FIG. 13 where four (or some other number of) antenna turns 32a are laid down on a substrate 30a to form an inner antenna turn 38a and an outer antenna turn 40a. Again, antenna pads 34a and 36a are positioned at a central area within the inner turn 38a, but in this case a bridging conductor 42a (FIG. 14) is mounted on the opposite side of the substrate 30a. Thus the extra area of dielectric between the bridging conductor and the bridged antenna turns and one processing step is eliminated, and it is only necessary to provide vias 46a and 48a through the substrate 30a, as shown in FIG. 14, to connect to antenna pads 36a and 34a.

Although the chip is shown as being mounted within the innermost turn of the antenna and on the same side of the substrate as the antenna, it will be readily appreciated that other chip placements may be employed. Thus the chip may be placed on the same side of the substrate as the antenna but outside of the outermost turn of the antenna, or the chip may be placed anywhere on the opposite side of the substrate and have its pads connected to the antenna pads by means of conductive vias extending through the substrate.

For mass production a continuous strip of paper identification labels having a plurality of RF tags positioned on successively adjacent portions of the strip may be fan folded for ease of handling and storage. To decrease the overall thickness of such a fan folded arrangement the chip positions may be varied from one RF tag to the next so that when folded the chips of successive layers are staggered. For example, FIG. 15 is a simplified plan view of a paper identification label 110 bearing an RF tag 112 comprised of a substrate 114 which carries antenna turns (not shown in FIG. 15) and a transponder circuit chip 116. The transponder chip is offset from a center portion of the substrate, being offset to one side as shown in FIG. 15. Alternatively, the chip may be offset toward one end or the other or may be offset both transversely and longitudinally from the center of the substrate 114. An elevational view of label 110 is shown in FIG. 16.

FIG. 17 illustrates portions of a continuous paper strip having a series of adjacent sections 120,122,124 and 126 thereof which are connected to one another along perforated lines 128,130, and 132, for example, and each of which bears a transponder 112a, 112b, 112c and 112d, respectively. Transponder chips 116a, 116b, 116c and 116d of the respective transponders are alternately displaced to one side or the other on successive transponder substrates, as shown in FIG. 17. When the overall strip 120, 122, 124, 126, etc. is fan folded, as shown in FIG. 18, the several chips are staggered and thus a more compact folding is accomplished. Each complete RF tag may be adhesively secured to any desired part of the paper identification label strip, and even may have some of the legible printing on the paper identification label printed directly over the RF tag cover layer.

It will be seen that a sprocketed flexible film can be used for the polyester dielectric substrate to enable high production volumes at low cost using the inverted "flip chip" mounting techniques described above. The inverted "flip chip" mounting technique replaces use of silicon wire bonding, which could not withstand rigors of ordinary tag use. The chip may be constructed by various known printed circuit techniques including low voltage CMOS processes employing EEPROM nonvolatile memories that are capable of storing up to 70 to 80 or more bits of digital information. The double metal layer chip pad construction enables the top surface of the chip to have only two pads separated by a relatively large distance, which may be in the order of about 0.76 mm (0.030 inches), to enable use of epoxy type adhesives. Use of such adhesives is not possible with conventional chip pad spacings, which are in the order of 100 microns. With the chip bonding pads positioned over active circuitry on the chip, adhesive bonding is employed because wire bonding could damage underlying circuitry.

Information carried in the RF chip may be the same as or similar to the optical bar code information and also similar to some of the printed information. Redundancy of the information enables any one of several different reading systems to be used. One advantage of employing both the RF tag and the optical bar code on the same identification label is to enable such an identification label to be utilized with either optical readers or RF interrogator reading circuits.

The described transponder tag enables incorporation of an RF reading system into the baggage routing and handling system with minimum changes in airline baggage tagging procedures. The described system, being readily incorporated into a standard paper strip identification label, is compatible with many different types of systems now in use, including bar codes, optical character recognition systems and also labels readable by the human eye.

The major portion of the described RF tag has a thickness in the order of about 150 microns, as it is formed solely by the substrate, the screen printed antenna windings and cover coat. The portion of the tag in the area of the chip includes the additional thickness of the chip and the chip protective material, and thus may have a total thickness of between about 1.5 to 2 millimeters.

## Claims

1. A remotely readable identification tag comprising:
a flexible substrate,
an antenna formed on said substrate,
a transponder circuit chip ,
means for mounting said chip on said substrate, and
means for electrically connecting said chip to said antenna;
wherein said antenna comprises a conductive coil formed on said substrate and having first and second electrical contact antenna pads, said circuit chip including first and second electrical contact chip pads on an inner surface portion of the chip, said means for electrically connecting said chip to said antenna comprising electrically conductive adhesive interposed between said antenna pads and said chip pads.

2. A tag according to Claim 1 wherein said antenna pads are formed on said substrate within an area thereof that is circumscribed by said antenna coil.

3. A tag according to Claim 2 wherein said coil is comprised of a plurality of turns including an inner turn and an outer turn, said inner turn being connected to one of said antenna pads within an area circumscribed by said inner turn, and said outer turn having an end connected to a second one of said antenna pads within said area circumscribed by said inner turn.

4. A tag according to Claim 3 including a bridging conductor extending across a plurality of said antenna turns and electrically connecting said outer turn to said second antenna pad within said inner turn.

5. A tag according to Claim 4 wherein said flexible substrate has first and second surfaces, said antenna turns being mounted on said first surface and said bridging conductor being mounted on said second surface, and means for connecting ends of said bridging conductor through said substrate to said outer turn and to said second antenna pad.

6. A tag according to Claim 1 wherein each said antenna pad includes an outer conductive area and an inner open area , and including conductive adhesive secured to said antenna pad and substrate within said open area.

7. A tag according to Claim 1 including a layer of protective material extending over and secured to said chip and said antenna.

8. A tag according to Claim 1 wherein said chip has electrical circuitry thereon and includes first and second chip primary contact pads electrically connected to said circuitry, a layer of dielectric material on said chip, and first and second chip secondary contact pads on said dielectric and electrically connected to said first and second primary pads respectively.

9. A tag according to Claim 8 wherein said secondary pads are larger than said primary pads and overly both said primary pads and portions of said circuitry.

10. A tag according to Claim 1 wherein said means for mounting said chip to said substrate includes a nonconductive structural adhesive bonded to said chip between said chip pads and bonded to said substrate between said antenna pads, said structural adhesive being positioned between and electrically insulating a first portion of said conductive adhesive from a second portion of said conductive adhesive.

11. A method for forming a remotely readable identification tag comprising:
forming a plurality of electrically conductive antenna turns on a flexible substrate,
forming first and second antenna contact pads on said turns,
providing a transponder circuit chip having first and second chip contact pads,
bonding said first and second chip pads to said first and second antenna pads respectively, thereby bonding said chip to said antenna and substrate, and
forming a protective covering over said chip and antenna;
wherein said step of bonding said chip pads to said antenna pads comprises the step of interposing first and second electrically conductive adhesive portions between said chip pads and respective ones of said antenna pads.

12. A method according to Claim 11 including the step of further bonding said chip to said substrate by positioning an electrically nonconductive structural adhesive between said conductive adhesive portions and between said chip and said substrate.

13. A method according to Claim 11 wherein said step of forming said antenna turns includes the step of forming an inner turn and an outer turn forming said antenna contact pads within said inner turn and electrically connecting said outer turn to one of the antenna contact pads within the inner turn.

14. A method according to Claim 11 wherein said step of forming antenna contact pads includes the step of forming a continuous peripheral conductor that circumscribes an open area thereof, and wherein said step of bonding comprises confining a conductive adhesive within said open area.

15. A tag according to Claim 1 wherein the form of a luggage identification tag comprising:
a flexible self-adhesive luggage identification strip configured and arranged to be secured around a luggage handle, and
said flexible substrate having a first side thereof adhesively secured to said luggage identification strip,
said antenna formed on said substrate having inner and outer turns,
said first and second antenna contact pads respectively connected with said inner and outer turns and positioned within an area circumscribed by said inner turn,
the tag further comprising structural adhesive bonded to and between said chip and substrate and positioned between said chip pads and between said antenna pads, and
a protective material covering said chip antenna and substrate.

16. A tag according to Claim 15 including an optical bar code on said luggage identification strip.

17. A tag according to Claim 15 wherein said chip includes circuitry on a surface thereof, said chip pads comprising relatively smaller primary pads positioned within an area encompassed by said circuitry, a layer of dielectric material on said chip covering said circuitry, and first and second relatively larger secondary pads on said dielectric and electrically connected to said primary pads.

18. A continuous multi-label strip of identification labels comprising:
a continuous strip of flexible label material separated into a plurality of mutually adjacent sections,
each said section comprising an independent luggage identification label, each said label comprising:
a flexible identification label strip base,
a flexible substrate secured to said base,
a plurality of antenna turns formed on said substrate, and
a transponder circuit chip secured to said substrate adjacent said antenna turns, the transponder chips of successive ones of said identification label sections being asymmetrically displaced in different directions from one identification label section to the next to facilitate folding and stacking of said label sections upon one another with transponder chips of mutually adjacent ones of said sections being in mutually staggered relation.

## Patentansprüche

1. Fernablesbarer Identifizierungsanhänger mit:
einem flexiblen Substrat,
einer auf dem Substrat gebildeten Antenne,
einem Transponder-Schaltungschip,
Mitteln zur Befestigung des genannten Chips auf dem Substrat, und
Mitteln zur elektrischen Verbindung des genannten Chips mit der genannten Antenne;
wobei die genannte Antenne eine auf dem Substrat gebildete leitfähige Spule aufweist und erste und zweite elektrische Antennenkontaktpunkte besitzt, wobei das genannte Schaltungschip erste und zweite elektrische Chipkontaktpunkte auf einem inneren Flächenteil des Chips aufweist und wobei die Mittel zur elektrischen Verbindung des Chips mit der Antenne elektrisch leitfähigen Klebstoff enthalten, der zwischen den Antennenanschlußpunkten und den Chipanschlußpunkten vorgesehen ist.

2. Anhänger nach Anspruch 1, bei welchem die Antennenanschlußpunkte auf dem Substrat innerhalb eines Bereiches desselben gebildet sind, der von der genannten Antennenspule umgrenzt ist.

3. Anhänger nach Anspruch 2, bei welchem die genannte Spule aus einer Mehrzahl von Windungen gebildet ist, die eine innere Windung und eine äußere Windung enthalten, wobei die innere Windung mit einem der Antennenanschlußpunkte innerhalb eines Bereiches verbunden ist, der von der genannten inneren Windung umgrenzt ist, und wobei die äußere Windung ein Ende aufweist, die mit einem zweiten der genannten Antennenanschlußpunkte innerhalb des von der inneren Windung umkreisten Bereiches verbunden ist.

4. Anhänger nach Anspruch 3, mit einem Überbrückungsleiter, der sich über eine Mehrzahl der genannten Antennenwindungen erstreckt und elektrisch die äußere Windung mit dem genannten zweiten Antennenanschlußpunkt innerhalb der inneren Windung verbindet.

5. Anhänger nach Anspruch 4, bei welchem das genannte flexible Substrat eine erste und eine zweite Oberfläche aufweist, die Antennenwindungen auf der ersten Oberfläche befestigt sind und der genannte Überbrückungsleiter auf der zweiten Oberfläche befestigt ist und wobei Mittel zur Verbindung der Enden des genannten Überbrückungsleiters durch das Substrat mit der äußeren Windung und mit dem zweiten Antennenanschlußpunkt vorgesehen sind.

6. Anhänger nach Anspruch 1, bei welchem jeder Antennenanschlußpunkt einen äußeren leitfähigen Bereich und eine innere offene Fläche aufweist und bei welchem leitfähiger Klebstoff vorgesehen ist, der mit dem genannten Antennenanschlußpunkt und dem Substrat innerhalb des offenen Bereiches fest verbunden ist.

7. Anhänger nach Anspruch 1, mit einer Schicht aus einem schützenden Werkstoff, die sich über das genannte Chip und die Antenne erstreckt und an diesen Teilen befestigt ist.

8. Anhänger nach Anspruch 1, bei welchem das genannte Chip eine elektrische Schaltungsanordnung trägt und erste und zweite primäre Chip-Kontaktpunkte aufweist, die elektrisch mit der genannten Schaltungsanordnung verbunden sind, bei welchem ferner eine Schicht aus dielektrischem Werkstoff auf dem Chip sowie erste und zweite sekundäre Chipkontaktpunkte auf dem genannten Dielektrikum vorgesehen sind und elektrisch mit dem ersten bzw. dem zweiten primären Anschlußpunkt verbunden sind.

9. Anhänger nach Anspruch 8, bei welchem die genannten sekundären Anschlußpunkte größer als die genannten primären Anschlußpunkte sind und sowohl die primären Anschlußpunkte als auch Teile der Schaltungsanordnung überdecken.

10. Anhänger nach Anspruch 1, bei welchem die genannten Mittel zur Befestigung des Chips an dem Substrat einen nicht leitfähigen strukturellen Klebstoff enthalten, der mit dem Chip zwischen den Chip-Anschlußpunkten sowie mit dem genannten Substrat zwischen den Antennenanschlußpunkten verbunden ist, wobei der strukturelle Klebstoff zwischen einem ersten Teil des genannten leitfähigen Klebstoffs und einem zweiten Teil des genannten leitfähigen Klebstoffs angeordnet ist und den genannten ersten Teil und den genannten zweiten Teil des leitfähigen Klebstoffs elektrisch voneinander isoliert.

11. Verfahren zur Bildung eines fernablesbaren Identifizierungsanhängers mit den Schritten des:
Bildens einer Mehrzahl elektrisch leitfähiger Antennenwindungen auf einem flexiblen Substrat,
Bildens erster und zweiter Antennenkontaktanschlußpunkte an den genannten Windungen,
Vorsehens eines Transponderschaltungschips mit ersten und zweiten Chipkontaktanschlußpunkten,
Verbindens der ersten und zweiten Chipanschlußpunkte mit dem ersten bzw. zweiten Antennenanschlußpunkt, wodurch das genannte Chip mit der Antenne und dem Substrat verbunden wird, und
Bildens einer Schutzabdeckung über dem Chip und der Antenne;
wobei der genannte Schritt des Verbindens der Chipanschlußpunkte mit den Antennenanschlußpunkten den Schritt der Zwischenschaltung erster und zweiter elektrisch leitfähiger Klebstoffbereiche zwischen den Chipanschlußpunkten und den jeweiligen Antennenanschlußpunkten umfaßt.

12. Verfahren nach Anspruch 11 mit dem weiteren Schritt des Verbindens des genannten Chips mit dem Substrat durch Vorsehen eines elektrisch nicht leitfähigen strukturellen Klebstoffs zwischen den genannten leitfähigen Klebstoffbereichen und zwischen dem Chip und dem Substrat.

13. Verfahren nach Anspruch 11, bei welchem der genannte Schritt des Bildens der Antennenwindungen den Schritt der Bildung einer inneren Windung und einer äußeren Windung, die Bildung der genannten Antennenkontaktpunkte innerhalb der inneren Windung und den Schritt der elektrischen Verbindung der äußeren Windung mit einem der Antennenkontaktpunkte innerhalb der inneren Windung umfaßt.

14. Verfahren nach Anspruch 11, bei welchem der Schritt der Bildung der Antennenkontaktpunkte den Schritt der Bildung eines durchgehenden Umfangsleiters umfaßt, der sich um einen offenen Bereich desselben herum erstreckt, und wobei der Schritt des Verbindens den Einschluß eines leitfähigen Klebstoffs innerhalb des offenen Bereiches umfaßt.

15. Anhänger nach Anspruch 1, in Gestalt eines Gepäckidentifizierungsanhängers, enthaltend:
einen flexiblen, selbstklebenden Gepäckidentifizierungsstreifen, der so gestaltet und ausgebildet ist, daß er zur Befestigung um einen Gepäckgriff herum angelegt werden kann, und
wobei das genannte flexible Substrat mit einer ersten Seite desselben klebend an dem Gepäckidentifizierungsstreifen befestigt ist,
die genannte Antenne auf dem Substrat gebildet und mit einer inneren und einer äußeren Windung ausgebildet ist,
der erste und der zweite Antennenkontaktanschlußpunkt jeweils mit der inneren bzw. der äußeren Windung verbunden ist und sich innerhalb einer von der inneren Windung umgrenzten Fläche befindet, und
wobei der Anhänger weiter strukturellen Klebstoff, der mit dem Chip und dem Substrat verbunden und zwischen diesen Teilen vorgesehen ist und zwischen den Chipanschlußpunkten und zwischen den Antennenanschlußpunkten angeordnet ist, sowie ein Schutzmaterial enthält, das das Chip, die Antenne und das Substrat überdeckt.

16. Anhänger nach Anspruch 15, mit einem optischen Barcode (Streifenkode) auf dem Gepäckidentifizierungsstreifen.

17. Anhänger nach Anspruch 15, bei welchem das Chip eine Schaltungsanordnung auf einer seiner Flächen enthält, wobei ferner die Chipanschlußpunkte verhältnismäßig kleinere primäre Anschlußpunkte aufweisen, die innerhalb einer von der genannte Schaltungsanordnung eingenommenen Fläche gelegen sind, wobei eine Schicht dielektrischen Materials auf dem Chip die Schaltungsanordnung überdeckt und erste und zweite verhältnismäßig größere sekundäre Anschlußpunkte auf der dielektrischen Schicht vorgesehen sind, die elektrisch mit den primären Anschlußpunkten verbunden sind.

18. Durchgehender Streifen einer Anzahl von Identifizierungsschildern mit:
einem kontiniuierlichen Streifen von flexiblem Schildermaterial, das in eine Mehrzahl von aneinander angrenzenden Abschnitten unterteilt ist, wobei jeder Abschnitt ein unabhängiges Gepäckidentifizierungsschild enthält und jedes Schild folgendes aufweist:
eine flexible Identifizierungsschild-Streifenbasis,
ein mit der genannten Basis fest verbundenes flexibles Substrat,
eine Mehrzahl von Antennenwindungen, die auf dem genannten Substrat gebildet ist, und
ein Transponder-Schaltungschip, das an dem Substrat benachbart den Antennenwindungen befestigt ist,
wobei die Transponderchips aufeinanderfolgender der Identifizierungsschildabschnitte asymmetrisch von einem Identifizierungsschildabschnitt zum nächsten Identifizierungsschildabschnitt in unterschiedlichen Richtungen versetzt sind, um ein Falten und Aufeinanderstapeln der Schildabschnitte zu erleichtern, wobei die Transponderchips jeweils benachbarter Abschnitte wechselseitig gestaffelt bzw. versetzt gelegen sind.

## Revendications

1. Étiquette d'identification lisible à distance comprenant :
un substrat souple ;
une antenne formée sur ledit substrat ;
une puce de circuit répondeur ;
un moyen destiné à monter ladite puce sur ledit substrat ; et
un moyen pour relier électriquement ladite puce à ladite antenne ;
dans laquelle ladite antenne comprend une bobine conductrice formée sur ledit substrat et comportant des première et seconde plages de connexion de contact électrique d'antenne ; ladite puce de circuit incluant des première et seconde plages de connexion de contact électrique de puce sur une partie de surface intérieure de la puce, ledit moyen destiné à connecter électriquement ladite puce à ladite antenne comprenant de la colle conductrice de l'électricité interposée entre lesdites plages de connexion d'antenne et lesdites plages de connexion de puce.

2. Étiquette selon la revendication 1, dans laquelle lesdites plages de connexion d'antenne sont formées sur ledit substrat à l'intérieur d'une zone de celui-ci qui est circonscrite par ladite bobine d'antenne.

3. Étiquette selon la revendication 2, dans laquelle ladite bobine est constituée de plusieurs tours incluant un tour intérieur et un tour extérieur, ledit tour intérieur étant connecté à l'une desdites plages de connexion d'antenne à l'intérieur d'une zone circonscrite par ledit tour intérieur, et ledit tour extérieur ayant une extrémité connectée à une seconde desdites plages de connexion d'antenne à l'intérieur de ladite zone circonscrite par ledit tour intérieur.

4. Étiquette selon la revendication 3, incluant un conducteur de pontage s'étendant en travers de plusieurs desdits tours d'antenne et reliant électriquement ledit tour extérieur à ladite seconde plage de connexion d'antenne à l'intérieur dudit tour intérieur.

5. Étiquette selon la revendication 4, dans laquelle ledit substrat souple comporte une première et une seconde faces, lesdits tours d'antenne étant montés sur ladite première face et ledit conducteur de pontage étant monté sur ladite seconde face, et un moyen destiné à connecter les extrémités dudit conducteur de pontage, à travers ledit substrat, audit tour extérieur et à ladite seconde plage de connexion d'antenne.

6. Étiquette selon la revendication 1, dans laquelle chacune desdites plages de connexion d'antenne comprend une zone conductrice extérieure et une zone ouverte intérieure, et comprenant de la colle conductrice fixée à ladite plage de connexion d'antenne et au substrat à l'intérieur de ladite zone ouverte.

7. Étiquette selon la revendication 1, incluant une couche de matière protectrice s'étendant sur ladite puce et ladite antenne et fixée à celles-ci.

8. Étiquette selon la revendication 1, dans laquelle ladite puce porte des circuits électriques et comprend des première et seconde plages de connexion de contact primaire de puce connectées électriquement auxdits circuits, une couche de matière diélectrique sur ladite puce, et des première et seconde plages de connexion de contact secondaire de puce sur ledit diélectrique et connectées électriquement, respectivement, auxdites première et seconde plages de connexion primaires.

9. Étiquette selon la revendication 8, dans laquelle lesdites plages de connexion secondaires sont plus grandes que lesdites plages de connexion primaires et recouvrent à la fois lesdites plages de connexion primaires et des parties desdits circuits.

10. Étiquette selon la revendication 1, dans laquelle ledit moyen destiné à monter ladite puce sur ledit substrat comprend une colle de construction non conductrice collée à ladite puce entre lesdites plages de connexion de puce et collée audit substrat entre lesdites plages de connexion d'antenne, ladite colle de construction étant placée entre, et isolant électriquement, une première partie de ladite colle conductrice d'une seconde partie de ladite colle conductrice.

11. Procédé de formation d'une étiquette d'identification lisible à distance, comprenant :
la formation de plusieurs tours d'antenne conducteurs de l'électricité sur un substrat souple ;
la formation de première et seconde plages de connexion de contact d'antenne sur lesdits tours ;
la fourniture d'une puce de circuit de répondeur comportant des première et seconde plages de connexion de contact de puce ;
le collage desdites première et seconde plages de connexion de puce, respectivement, auxdites première et seconde plages de connexion d'antenne, en collant ainsi ladite puce à ladite antenne et audit substrat, et
la formation d'une couverture protectrice sur ladite puce et ladite antenne ;
dans lequel ladite étape de collage desdites plages de connexion de puce auxdites plages de connexion d'antenne comprend l'étape d'interposition de première et seconde parties de colle conductrice de l'électricité entre lesdites plages de connexion de puce et celles qui leur correspondent desdites plages de connexion d'antenne.

12. Procédé selon la revendication 11, incluant l'étape supplémentaire de collage de ladite puce audit substrat en plaçant une colle de construction non conductrice de l'électricité entre lesdites parties de colle conductrice et entre ladite puce et ledit substrat.

13. Procédé selon la revendication 11, dans lequel ladite étape de formation desdits tours d'antenne comprend l'étape de formation d'un tour intérieur et d'un tour extérieur, de formation desdites plages de connexion de contact d'antenne à l'intérieur dudit tour intérieur et de connexion électrique dudit tour extérieur à l'une des plages de connexion de contact d'antenne à l'intérieur du tour intérieur.

14. Procédé selon la revendication 11, dans lequel ladite étape de formation des plages de connexion de contact d'antenne comprend l'étape de formation d'un conducteur périphérique continu qui circonscrit une zone ouverte de celui-ci, et dans lequel ladite étape de collage comprend le confinement d'une colle conductrice à l'intérieur de ladite zone ouverte.

15. Étiquette selon la revendication 1, lorsqu'elle est sous la forme d'une étiquette d'identification de bagage, comprenant :
une bande souple, autocollante, d'identification de bagage, conformée et agencée pour être fixée autour d'un bagage à main ; et
dans lequel une première des faces dudit substrat souple est collée à ladite bande d'identification de bagage ;
ladite antenne formée sur ledit substrat ayant des tours intérieur et extérieur ;
lesdites première et seconde plages de connexion de contact d'antenne étant connectées respectivement auxdits tours intérieur et extérieur et placés à l'intérieur d'une zone circonscrite par ledit tour intérieur ;
l'étiquette comprenant en outre :
une colle de construction collée à, et entre, ladite puce et ledit substrat et placée entre lesdites plages de connexion de puce entre lesdites plages de connexion d'antenne ; et
une matière protectrice recouvrant ladite puce, ladite antenne et ledit substrat.

16. Étiquette selon la revendication 15, incluant un code à barres optique sur ladite bande d'identification de bagage.

17. Étiquette selon la revendication 15, dans laquelle ladite puce comprend des circuits sur l'une de ses faces, lesdites plages de connexion de puce comprenant des plages de connexion primaires relativement plus petites placées à l'intérieur d'une zone comprise à l'intérieur desdits circuits, une couche de matière diélectrique sur ladite puce recouvrant lesdits circuits, et des première et seconde plages de connexion secondaires relativement plus grandes sur ledit diélectrique et connectées électriquement auxdites plages de connexion primaires.

18. Bande continue, à étiquettes multiples, d'étiquettes d'identification, comprenant :
une bande continue de matière à étiquettes, souple, divisée en plusieurs sections mutuellement adjacentes :
chacune desdites sections constituant une étiquette indépendante d'identification de bagage, chacune desdites étiquettes comprenant :
une base souple de bande d'étiquettes d'identification ;
un substrat souple fixé à ladite base ;
plusieurs tours d'antenne formés sur ledit substrat ; et
une puce de circuit répondeur fixée audit substrat à côté desdits tours d'antenne ;
les puces répondeurs de celles qui se succèdent desdites sections d'étiquette d'identification étant décalées de façon asymétrique dans des directions différentes, d'une section d'étiquette d'identification à la suivante, pour faciliter le pliage et l'empilement desdites sections d'étiquette, l'une sur l'autre, avec les puces de répondeur de celles qui sont mutuellement adjacentes desdites sections qui se trouvent dans une disposition mutuellement décalée.
